# EUROPEAN PATENT SPECIFICATION

(11) **EP 3 087 811 B1**
(45) Date of publication and mention of the grant of the patent: **21.08.2024**
(21) Application number: 14812280.7
(22) Date of filing: 27.11.2014
(51) Int. Cl.: H05K 1/02, H05K 3/12

(54) **A SUBSTRATE SCAFFOLD STRUCTURE AND ASSOCIATED APPARATUS AND METHODS**
SUBSTRATGERÜSTAUFBAU SOWIE ZUGEHÖRIGE VORRICHTUNG UND VERFAHREN
STRUCTURE D'ÉCHAFAUDAGE DE SUBSTRAT ET APPAREIL ET PROCÉDÉS ASSOCIÉS

(30) Priority: 23.12.2013 GB 201322885
(43) Date of publication of application: 02.11.2016
(73) Proprietor: Nokia Technologies Oy, 02610 Espoo (FI)
(72) Inventor: ALLEN, Mark, Great Cambourne Cambs CB23 6BA (GB); COTTON, Darryl, St. Ives Cambridgeshire PE27 JX (GB); BOWER, Chris, Ely Cambridgeshire CB6 3EN (GB); ANDREW, Piers, Highfields Caldecote Cambridge CB23 7UZ (GB)
(74) Representative: Novagraaf Technologies
(86) International application number: PCT/FI2014/050919
(87) International publication number: WO 2015/097340

(56) References cited:
- EP-A1- 3 055 017
- WO-A1-2015/052029
- KR-A- 20100 018 006
- US-A1- 2004 192 082
- US-A1- 2005 006 788
- US-A1- 2006 159 838
- US-A1- 2006 169 672
- US-A1- 2006 169 989
- US-A1- 2007 125 486
- US-A1- 2008 157 235
- US-A1- 2010 002 402
- US-A1- 2010 143 848
- US-A1- 2010 163 281
- US-A1- 2012 043 115

## Description

### Technical Field

The present disclosure relates to the field of device fabrication, associated methods and apparatus, and in particular concerns a substrate scaffold structure for use in the fabrication of a reversibly deformable circuit board. Certain disclosed example aspects/embodiments relate to portable electronic devices, in particular, so-called hand-portable electronic devices which may be hand-held in use (although they may be placed in a cradle in use). Such hand-portable electronic devices include so-called Personal Digital Assistants (PDAs) and tablet PCs.

The portable electronic devices/apparatus according to one or more disclosed example aspects/embodiments may provide one or more audio/text/video communication functions (e.g. tele-communication, video-communication, and/or text transmission, Short Message Service (SMS)/ Multimedia Message Service (MMS)/emailing functions, interactive/non-interactive viewing functions (e.g. web-browsing, navigation, TV/program viewing functions), music recording/playing functions (e.g. MP3 or other format and/or (FM/AM) radio broadcast recording/playing), downloading/sending of data functions, image capture function (e.g. using a (e.g. in-built) digital camera), and gaming functions.

### Background

The development of stretchable electronics remains limited by the relative inability of materials to withstand mechanical deformation. In particular, inorganic thin film dielectrics and semiconductors, as well as the transparent conductors used in optoelectonics, are brittle, fragile and tend to crack when mechanically deformed.

One or more aspects/embodiments of the present disclosure may or may not address this issue.

The listing or discussion of a prior-published document or any background in this specification should not necessarily be taken as an acknowledgement that the document or background is part of the state of the art or is common general knowledge. Patent document KR2010018006A teaches a method for use in the fabrication of a reversibly deformable circuit board that implies depositing a conductive layer 110 on a patterned flexible substrate 100. The resulting circuit board comprises a conductive layer 110 having a pattern corresponding to the pattern of the substrate 100.

### Summary

The present invention comprises a method for use in the fabrication of a reversibly deformable circuit board and a reversibly deformable circuit board as defined in the claims.

The waveform topography of the substrate scaffold structure may be predefined to facilitate reversible deformation of the electronic circuit elements during operational reversible deformation of the circuit board.

The method may comprise forming the substrate scaffold structure from, or on top of, a reversibly deformable substrate of the circuit board.

The method may comprise depositing a scaffold-conforming support layer on top of the substrate scaffold structure before deposition of the one or more scaffold-conforming thin film layers to reduce the formation of defects in the one or more scaffold-conforming thin film layers caused by removal of the substrate scaffold structure.

The method may comprise transferring the one or more scaffold-conforming thin film layers onto a reversibly deformable substrate of the circuit board after removal of the substrate scaffold structure and whilst the reversibly deformable substrate is in a relaxed state.

Forming the substrate scaffold structure may comprise:
modifying the surface chemistry of the substrate in a pattern corresponding to the predefined waveform topography; depositing an ink onto the modified surface of the substrate; allowing interactions between the ink and the modified surface to form a plurality of ink droplets in substantially the same pattern as the modified surface; and heating the substrate to cure the ink droplets. The ink may be a fluid. In an example not forming part of the invention, modifying the surface chemistry of the substrate may comprise forming a pattern of fluidphobic and/or fluidphilic regions on the surface of the substrate.

The method may comprise removing the substrate scaffold structure after deposition of the one or more scaffold-conforming thin film layers.

The method may comprise forming the one or more scaffold-conforming thin film layers to allow access to the underlying substrate scaffold structure to enable its removal.

The method may comprise depositing a plurality of scaffold-conforming thin film layers on top of the substrate scaffold structure. The method may comprise removing the substrate scaffold structure after the first thin film layer has been deposited but before the last thin film layer has been deposited.

The steps of any method disclosed herein do not have to be performed in the exact order disclosed, unless explicitly stated or understood by the skilled person.

Corresponding computer programs (which may or may not be recorded on a carrier) for implementing one or more of the methods disclosed herein are also within the present disclosure and encompassed by one or more of the described example embodiments.

In examples not forming part of the invention, the waveform topography of the substrate scaffold structure may be predefined according to one or more of an expected level of operational reversible deformation, the type of electronic circuit elements, the materials from which the one or more scaffold-conforming thin film layers are formed, and the thicknesses of the one or more scaffold-conforming thin film layers.

In examples not forming part of the invention, the substrate scaffold structure may comprise a continuous or discontinuous waveform topography.

The predefined waveform topography may be substantially uniform across the substrate scaffold structure. The predefined waveform topography may vary from one region of the substrate scaffold structure to another. One or more of the period, amplitude, direction and shape of the predefined waveform topography may vary from one region of the substrate scaffold structure to another.

The predefined waveform topography may have a period of 10-100µm. The predefined waveform topography may have a peak-to-peak amplitude of 1-50µm. These values may be limiting for some applications, although useful for others. For example, using photolithography on PCBs, 100µm may be a lower track width and the maximum track width may be in the mm scale. Thus, in certain applications, the period/peak-to-peak amplitude of the predefined waveform may be in 100µm to mm range. In the case of nano-scale in integrated circuits, track dimensions in the 0.05nm thickness range (e.g. for grapheme) and possibly 1nm wide, would require the period and amplitude to be reduced to the nano-scale, which may result in a reduction in volume of a device. Thus, in certain applications, the period/peak-to-peak amplitude of the predefined waveform may be in nanometre range. In the case of wearable devices, we may have a Lycra substrate and the waveform might have a period and/or peak to peak amplitude in the mm scale.

In an example not forming part of the invention, the substrate scaffold structure may have a generally planar configuration. The predefined waveform topography may comprise one or more of a uniaxial, biaxial and radial waveform in the plane of the substrate scaffold structure.

The predefined waveform topography may comprise one or more of a substantially sinusoidal, substantially square, substantially triangular and substantially sawtooth waveform.

The predefined waveform topography comprises a main waveform and a sub-waveform formed on top of the main waveform. The sub-waveform has a smaller period and amplitude than the main waveform. The predefined waveform topography may comprise one or more further sub-waveforms formed on top of the main and sub-waveforms. Each further sub-waveform may have a smaller period and amplitude than the hierarchically preceding waveform.

In an example not forming part of the invention, the substrate scaffold structure may be formed from a material, which sublimes (phase change directly from solid to vapour) at a temperature between 100 °C and 200 °C. The substrate scaffold structure may be formed from trimethylolethane.

In an example not forming part of the invention, the substrate scaffold structure may be formed from a reversibly deformable material. In an example not forming part of the invention, the substrate scaffold structure comprises one or more of polyurethane, polydimethylsiloxane and low-density polyethylene. The Young's modulus of such materials is typically in the range of 1 to 100 MPa.

According to a further aspect, in examples not forming part of the invention, there is provided a reversibly deformable circuit board comprising electronic circuit elements formed from one or more thin film layers of the reversibly deformable circuit board, wherein the one or more thin film layers comprise a predefined waveform configuration for facilitating operational reversible deformation of the circuit board between a relaxed state and a strained state, and wherein the electronic circuit elements are in a substantially neutral stress state when the reversibly deformable circuit board is in the relaxed state.

The reversibly deformable circuit board comprises a substrate scaffold structure having a predefined waveform topography on which the one or more thin film layers are formed. The predefined waveform configuration of the one or more thin film layers may substantially correspond to the predefined waveform topography of the substrate scaffold structure.

In an example not forming part of the invention, the substrate scaffold structure may be a reversibly deformable substrate of the circuit board. The substrate scaffold structure may be formed on top of a reversibly deformable substrate of the circuit board. The reversibly deformable substrate may comprise one or more of a metal, glass, polymer and textile.

The one or more thin film layers may comprise conducting, semiconducting, electroluminescent, piezoelectric, piezoresistive, sensing and/or insulating layers as well as barrier layers to prevent water vapour penetration. The one or more thin film layers may have individual thicknesses of 10-3000nm (or 0.05nm for graphene) and a total combined thickness of less than 5µm (in the case of the mm scale, thickness could be much higher e.g. 500µm). The one or more thin film layers may be formed from reversibly deformable and/or brittle materials. The one or more thin film layers may be formed from a continuous interconnected array of carbon nanotubes, graphene flakes, or metallic nanowires, or fine line metal.

The electronic circuit elements may comprise one or more electronic components and/or conductive traces for connecting electronic components. The electronic components may comprise one or more of a transistor, a diode, photodiodes, an organic light-emitting diodes (OLEDs), a light-emitting electrochemical cells (LEC), a solar cell, a sensor, an antenna, and a touch sensor. The electronic circuit elements may comprise optically transparent conductive traces and electronic components. One or more of the scaffold-comforming thin-film layers may also be a barrier layer(s) for water vapour.

The reversibly deformable circuit board may be a motherboard or module for an electronic device.

The present disclosure includes one or more corresponding aspects, example embodiments or features in isolation or in various combinations whether or not specifically stated (including claimed) in that combination or in isolation. Corresponding means for performing one or more of the discussed functions are also within the present disclosure.

The above summary is intended to be merely exemplary and non-limiting.

### Brief Description of the Figures

A description is now given, by way of example only, with reference to the accompanying drawings, in which:-
Figure 1 illustrates schematically reversible deformation of the electronic layers of an existing flexible/stretchable circuit board;
Figure 2 illustrates schematically the compressive and tensile stresses acting on the electronic layers when the flexible/stretchable circuit board is in a relaxed state;
Figure 3a illustrates schematically formation of a substrate scaffold structure on top of a reversibly deformable substrate;
Figure 3b illustrates schematically deposition of one or more scaffold-conforming thin film layers on top of the substrate scaffold structure;
Figure 3c illustrates schematically removal of the substrate scaffold structure after deposition of the one or more scaffold-conforming thin film layers;
Figure 4 illustrates schematically one or more scaffold-conforming thin film layers comprising holes to facilitate removal of the substrate scaffold structure;
Figure 5a illustrates schematically the resulting waveform configuration of the one or more scaffold-conforming thin film layers formed using the method of Figures 3a-3c;
Figure 5b illustrates schematically the one or more scaffold-conforming thin film layers under tensile strain;
Figure 6a illustrates schematically a substrate scaffold structure comprising a continuous waveform topography formed from a substrate;
Figure 6b illustrates schematically a substrate scaffold structure comprising a continuous waveform topography formed on top of a substrate;
Figure 6c illustrates schematically a substrate scaffold structure comprising a discontinuous waveform topography formed on top of a substrate;
Figure 7 illustrates schematically a substrate scaffold structure formed by depositing ink onto a chemically-modified substrate surface;
Figure 8a illustrates schematically a substrate scaffold structure comprising a uniaxial waveform topography;
Figure 8b illustrates schematically a substrate scaffold structure comprising a biaxial waveform topography;
Figure 9 illustrates schematically a predefined waveform topography comprising a main waveform and a sub-waveform;
Figure 10a shows an ink which is suitable for use in forming the substrate scaffold structure;
Figure 10b shows the formation of ink droplets using the ink of Figure 10a;
Figure 11a shows a series of parallel lines formed by printing the ink onto a substrate;
Figure 11b shows discontinuities in the parallel lines of Figure 11a;
Figure 11c shows a profile scan of the parallel lines;
Figure 11d shows a measurement of the line profile;
Figure 12a shows thin film layers of titanium and gold deposited on top of the parallel lines of Figure 11a;
Figure 12b is a first magnified view of Figure 12a from above;
Figure 12c is a second magnified view of Figure 12a from above;
Figure 12d is a magnified view of Figure 12a from below;
Figure 13a shows the substrate of Figure 12a after sublimation of the ink;
Figure 13b is a magnified view of Figure 13a from above;
Figure 13c shows a resistance measurement of the thin film layers;
Figure 13d shows a profile scan of the thin film layers;
Figure 13e shows a measurement of the thin film profile;
Figure 14a is a magnified view of Figure 13a from above showing breaks in the thin film layers caused by sublimation of the ink;
Figure 14b is a magnified view of Figure 13a from below showing breaks in the thin film layers caused by sublimation of the ink;
Figure 15 illustrates schematically an apparatus comprising a circuit board formed using the substrate scaffold structure described herein;
Figure 16 shows the main steps of a method of making a reversibly deformable circuit board using the substrate scaffold structure described herein; and
Figure 17 shows a computer-readable medium comprising a computer program configured to perform, control or enable one or more of the method steps of Figure 16.

### Description of Specific Aspects/Embodiments

One way to make stretchable electronic circuits is to fabricate them from wavy or ripple-like films or layers which can accommodate strain upon extension and/or compression, rather like a spring. These films are typically deposited on top of a stretchable substrate held in uniaxial, biaxial or radial tension. In one implementation, the films are locally, rather than globally, bonded to the substrate, so that when the substrate is allowed to relax back to its original form, a wavy structure of defined period and amplitude forms (each wave trough corresponding to a bonded position). In a second implementation, the electronic layers are globally bonded to the substrate, in which case the period and amplitude of the wavy structures is dependent upon the thickness and material properties of the layers and the substrate, and applied pre-strain.

Both of the above-mentioned methods require that the substrate is pre-stretched, which is not usually compatible with continuous, roll-to-roll manufacturing. Uniaxial pre-stretching may be simpler than biaxial pre-stretching, but is still difficult to control.

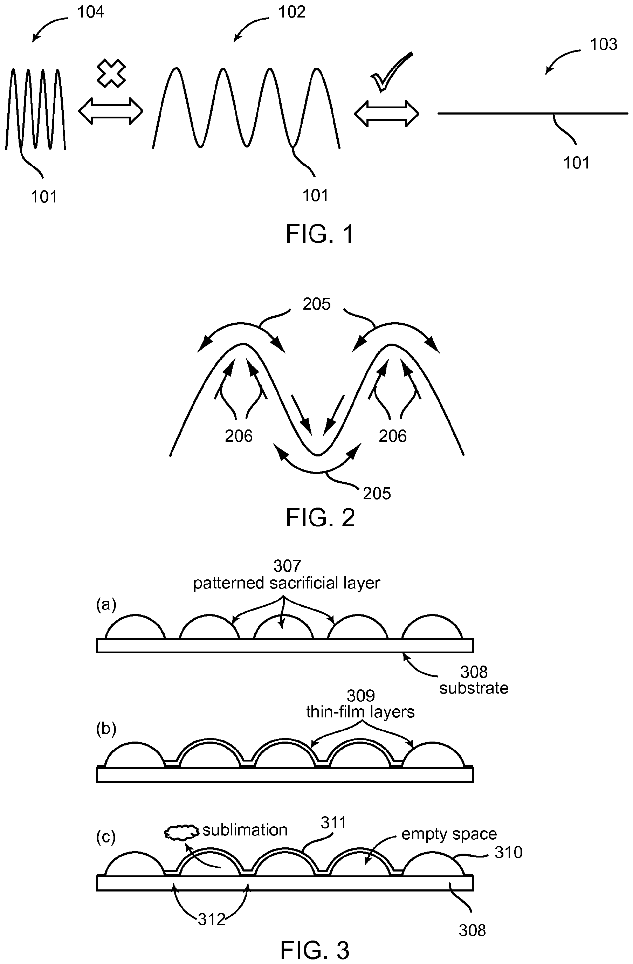

Another issue is that once the substrate has been allowed to return to the relaxed state, the resulting wavy sections will have a preloaded bend stress. Figure 1 illustrates reversible deformation of the electronic layers 101 between relaxed 102, stretched 103 and compressed 104 states, and Figure 2 illustrates the stresses acting on the electronic layers when the circuit board is in the relaxed state. As shown in Figure 2, there is a maximum tensile stress 205 on the top surfaces of the peaks (bottom surfaces of the troughs) and a maximum compressive stress 206 on the bottom surfaces of the peaks (top surfaces of the troughs). Hence, the electronic layers formed this way will be placed under stress in the relaxed state, which can be problematic because most electronic (and in particular optoelectronic) materials are brittle and fail (e.g. crack) at a lower tensile stress 205 than compressive stress 206.

A further issue with the above-mentioned fabrication processes is that when the circuit board is compressed from the relaxed state, the tensile 205 and compressive 206 stresses acting on the electronic layers 101 are increased, which can cause even greater damage to the electronic components and traces.

There will now be described an apparatus and associated methods that may or may not provide a solution to one or more of these issues.

The present approach involves the formation of a substrate scaffold structure for use in the fabrication of a reversibly deformable circuit board, the substrate scaffold structure comprising a predefined waveform topography onto which one or more scaffold-conforming thin film layers can be deposited for use in forming electronic circuit elements of the reversibly deformable circuit board.

The particular predefined waveform topography of the substrate scaffold structure allows the one or more scaffold-conforming thin film layers to adopt a substantially corresponding waveform configuration when deposited. This predefined waveform topography allows the scaffold-conforming thin film layers, and the electronic circuit elements formed from the thin film layers, to accommodate operational reversible deformation of the circuit board. Furthermore, the locations of the stresses and strains on the one or more scaffold-conforming thin film layers can be better controlled compared with current fabrication processes due to the fact that the waveform configuration of the thin film layers is predefined according to the operational use case.

The technique is illustrated schematically in Figure 3. The first step is formation of the substrate scaffold structure 307. The substrate scaffold structure 307 may be formed on top of a reversibly deformable substrate 308 of the circuit board as shown in Figure 3a, or it may be formed on a separate substrate. Alternatively, the substrate scaffold structure 307 may be formed from the substrate 308 (either the reversibly deformable substrate or the separate substrate) itself, as detailed below.

A number of different processes can be used to form the substrate scaffold structure 307.

For example, a layer of material may be embossed or moulded to impart the predefined waveform topography; a layer of material may be exposed to a beam of incident particles or electromagnetic radiation in a pattern corresponding to the predefined waveform topography and subsequently developed using a solvent; a layer of material may be etched through a mask having a pattern corresponding to the predefined waveform topography; a layer of material may be ablated using a beam of incident particles or electromagnetic radiation in a pattern corresponding to the predefined waveform topography; or a layer of material may be deposited on top of a substrate in a pattern corresponding to the predefined topography.

The patterned deposition option could even be performed in different ways. One method is to direct-write print (including inkjet printing, aerosol jet printing, dispensing) the scaffold forming material 307 onto the substrate 308 in a pattern corresponding to the predefined waveform topography or gravure print, flexographic print, offset print, screen print, or stencil print, or pad print the scaffold forming material 307 onto the substrate 308 in a pattern corresponding to the predefined waveform topography. Another method is to deposit the layer of material through a mask having a pattern corresponding to the predefined waveform topography. Another method is to modify the surface chemistry of the substrate in a pattern corresponding to the predefined waveform topography, and deposit an ink onto the modified surface of the substrate. In this way, interactions between the ink and the modified surface can be used to form a plurality of ink droplets in substantially the same pattern as the modified surface, which can then be cured by heating the substrate. The surface of the substrate may be modified by forming a pattern of fluidphobic and/or fluidphilic regions. For example, if the ink is water based, the pattern could be formed from hydrophobic and/or hydrophilic regions. On the other hand, of the ink is oil based, the pattern could be formed from lipophobic/ lyophobic (oleophobic) and/or lipophilic/ lyophillic (oleophilic) regions.

The next step is deposition of the one or more scaffold-conforming thin film layers 309 on top of the substrate scaffold structure 307, as shown in Figure 3b. When the substrate scaffold structure 307 is formed from, or on top of, a reversibly deformable substrate 308 of the circuit board, the thin film layers 309 should be deposited whilst the reversibly deformable substrate 308 is in a relaxed state (i.e. not substantially stretched, compressed or bent). Similarly, when the substrate scaffold structure 307 is formed from, or on top of, a separate substrate, the thin film layers 309 should be transferred (with or without the substrate scaffold structure 307 and separate substrate) onto a reversibly deformable substrate 308 of the circuit board whilst the reversibly deformable substrate 308 is in a relaxed state. This reduces the magnitude of stress/strain on the one or more thin film layers 309 for two reasons. First of all, there is no preloaded bend stress acting on the thin film layers 309 when the circuit board is relaxed. Therefore, unlike the electronic layers 101 of the prior art (see Figure 1), the thin film layers 309, and the electronic circuit elements formed from the thin film layers 309, are in a substantially neutral stress state. Accordingly, fewer stress concentration effects should be observed at the apexes of the peaks/troughs in the neutral stress state than the prior art. Secondly, because the thin film layers 309 are in a substantially neutral stress state when the circuit board is relaxed, the layers 309/circuit elements can better accommodate the compressive stresses introduced when the circuit board is compressed from the relaxed state to a compressed state (compare with prior art illustrated in left-hand side of Figure 1).

Another advantage associated with depositing/transferring the one or more scaffold-conforming thin film layers 309 when the reversibly deformable substrate 308 of the circuit board is in a relaxed state is that the deposition/transfer step can be performed using a roll-to-roll or sheet-fed process, which is not possible with the above-mentioned prior art techniques. In practice, the scaffold-conforming thin film layers 309 may be deposited on top of the substrate scaffold structure 307 using one or more of sputtering, evaporation, chemical vapour deposition, atomic layer deposition, spin-coating, spray-coating, screen printing, inkjet printing and aerosol deposition, roll coating, slot die coating, slide hopper coating, air knife coating, blade coating. It some instances, it may be necessary to heat the substrate scaffold structure 307 after deposition to cure the one or more scaffold-conforming thin film layers 309.

Once the one or more scaffold-conforming thin film layers 309 have been deposited onto the substrate scaffold structure 307, the scaffold structure 307 itself may be removed. This is shown schematically in Figure 3c. Whether or not the scaffold structure 307 should be removed depends on the material from which it is made. If the substrate scaffold structure 307 is formed from a reversibly deformable material, then it could be retained as an additional substrate layer of the circuit board. If, however, the substrate scaffold structure 307 is formed from a rigid material, then it should be removed to facilitate operational reversible deformation of the circuit board. Other factors which may affect the decision of whether or not to remove the substrate scaffold structure 307 include the weight of the structure 307 (which will depend on the material and thickness of the substrate scaffold structure 307), whether or not the thin film layers 309 can retain the predefined waveform configuration without the presence of the substrate scaffold structure 307 (which will depend on the materials and thicknesses of the thin film layers 309), and potential damage to the overlying thin film layers 309 caused by its removal.

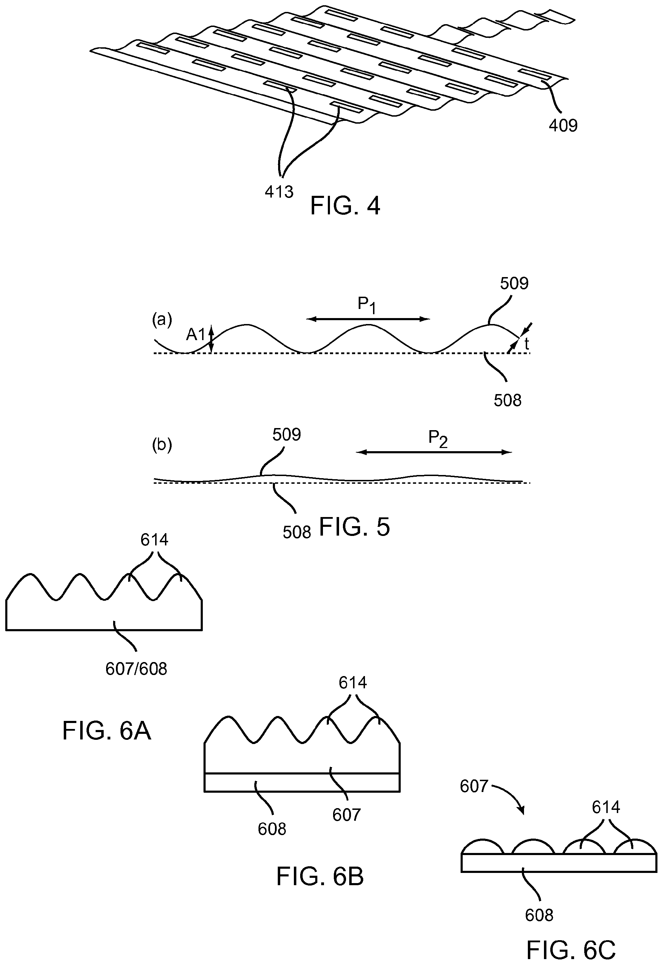

Figure 3c shows removal of the substrate scaffold structure 307 by sublimation (through an aperture, not shown), but other methods such as dissolution or etching could be used instead. In order to reduce the formation of defects in the one or more scaffold-conforming thin film layers 309 caused by removal of the substrate scaffold structure 307, a scaffold-conforming support layer (not shown) may be deposited on top of the substrate scaffold structure 307 before deposition of the thin film layers 309. Additionally or alternatively, the one or more scaffold-conforming thin film layers 309 may be formed to allow access to the underlying scaffold structure 307. As shown in Figure 4, this could comprise the formation of one or more holes 413 in the thin film layers 409 during or after their deposition.

It is not absolutely necessary to wait until the last scaffold-conforming thin film layer 311 has been deposited before removing the substrate scaffold structure 307. In actual fact, the substrate scaffold structure 307 may be removed any time after the first thin film layer 310 has been deposited (and dried) because the subsequent layers 311 will conform to the waveform configuration of the first thin film layer 310.

Once the substrate scaffold structure 307 has been removed, the one or more scaffold-conforming thin film layers 309 will remain on (or can be transferred to) the surface of the reversibly deformable circuit board substrate 308 such that only the bottom surfaces 312 of the troughs are in contact with the substrate 308. When the substrate is in the relaxed state, as shown in Figure 5a, the thin film layers 509 will have a combined thickness t and a waveform configuration with amplitude A₁ and period P₁. If the substrate 508 is then stretched or compressed from the relaxed state, the amplitude and period of the thin film layers 509 will vary to accommodate the change. This is illustrated in Figure 5b where the amplitude has decreased and the period P₂ has increased on stretching the reversibly deformable substrate 508.

The substrate scaffold structure could be formed with a variety of different waveform topographies. In practice, the waveform topography may be predefined according to one or more of an expected level of operational reversible deformation, the type of electronic circuit elements, the materials from which the one or more scaffold-conforming thin film layers are formed, and the thicknesses of the one or more scaffold-conforming thin film layers. The expected level of operational reversible deformation will depend on the apparatus/device for which the circuit board is being made. For example, if the end device comprises a compact but fixed casing, the circuit board may need to be bent and/or stretched during installation only. If, however, the casing of the device will be expected to change configuration repeatedly (e.g. in the way that a laptop opens and closes), the circuit board will likely need to tolerate regular bending and/or stretching. This ability to withstand regular bending and/or stretching is particular important for textile electronics where the electronic circuit elements are formed on or within items of clothing.

The substrate scaffold structure may comprise a continuous or discontinuous waveform topography. Figure 6a shows one example of a substrate scaffold structure 607 having a continuous waveform topography which is formed from a reversibly deformable circuit board substrate 608, whilst Figure 6b shows one example of a substrate scaffold structure 607 having a continuous waveform topography which is formed from a separate substrate and subsequently transferred to a (planar) reversibly deformable circuit board substrate 608. The term "continuous" in this sense simply means that the waveform topography comprises a plurality of connected protrusions 614. This contrasts with the substrate scaffold structure 607 shown in Figure 6c which has a discontinuous waveform topography and is formed on top of a reversibly deformable circuit board substrate 608. In this example, the waveform topography comprises a plurality of disconnected protrusions 614 which resemble islands on the surface of the substrate 608.

A disconnected waveform topography can be advantageous in situations where the substrate scaffold structure 607 is removed after deposition of the one or more scaffold-conforming thin film layers. This is because such topographies allow the thin film layers to be deposited onto the reversibly deformable substrate 608 of the circuit board in the gaps in the substrate scaffold structure 607, which helps to secure the thin film layers in place on the underlying substrate 608.

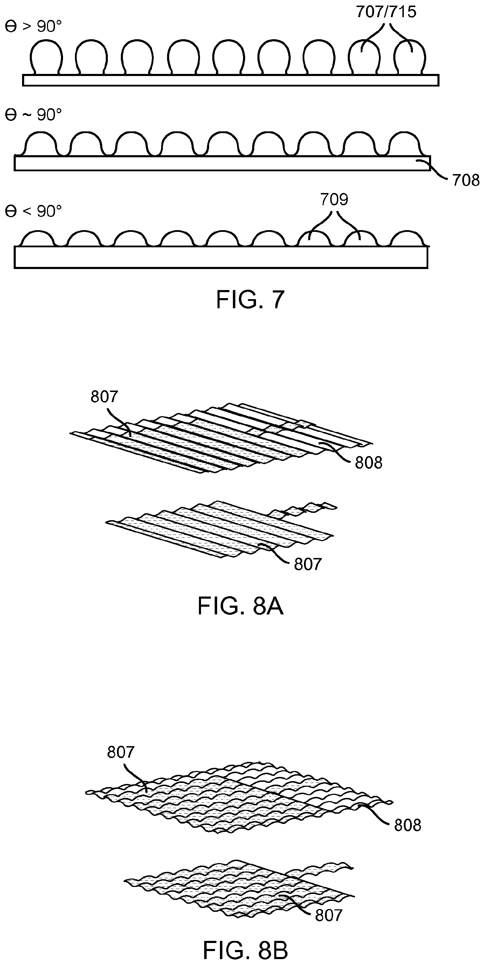

One technique which is particularly useful for forming a disconnected waveform topography is the deposition of ink onto a chemically-modified surface. As mentioned previously, a pattern of fluidphobic and/or fluidphilic regions may be created on the substrate surface to control the location and shape of the ink droplets. In particular, by varying the phobicity/philicity of the regions, the contact angle of the ink on the surface, and therefore the shape of the resulting waveform, can be carefully controlled. This is illustrated in Figure 7 which shows ink droplets 715 with a contact angle of greater than 90°, 90° and less than 90°. A contact angle of 90° or less is typically more desirable, because it can be difficult to deposit layers 709 which conform to the topography of an underlying substrate scaffold structure 707 having a contact angle of over 90° (although atomic layer deposition or chemical vapour deposition could be used for this purpose).

The waveform topography of the substrate scaffold structure may be substantially uniform across the substrate scaffold structure, or it could vary from one region of the structure to another. For example, the period, amplitude and/or shape of the waveform topography could vary from one region to the next. This feature may be useful if some regions of the circuit board are expected to bend or stretch more than others. One example is a flexible/stretchable circuit board which extends across the hinge between the keyboard and display of a laptop computer. In this scenario, any electronic circuit elements formed at the hinge region of the circuit board would be expected to bend or stretch more than those formed in the keyboard and display regions of the circuit board.

The waveform topography of the substrate scaffold structure may be predefined to allow the one or more scaffold-conforming thin film layers to accommodate mechanical deformation in different directions. For example, the predefined waveform topography may comprise one or more of a uniaxial (Figure 8a), biaxial (Figure 8b) and radial (not shown, but consider ripples from a centre point) waveform in the plane of the substrate scaffold structure 807, which is also the plane of the reversibly deformable substrate 808.

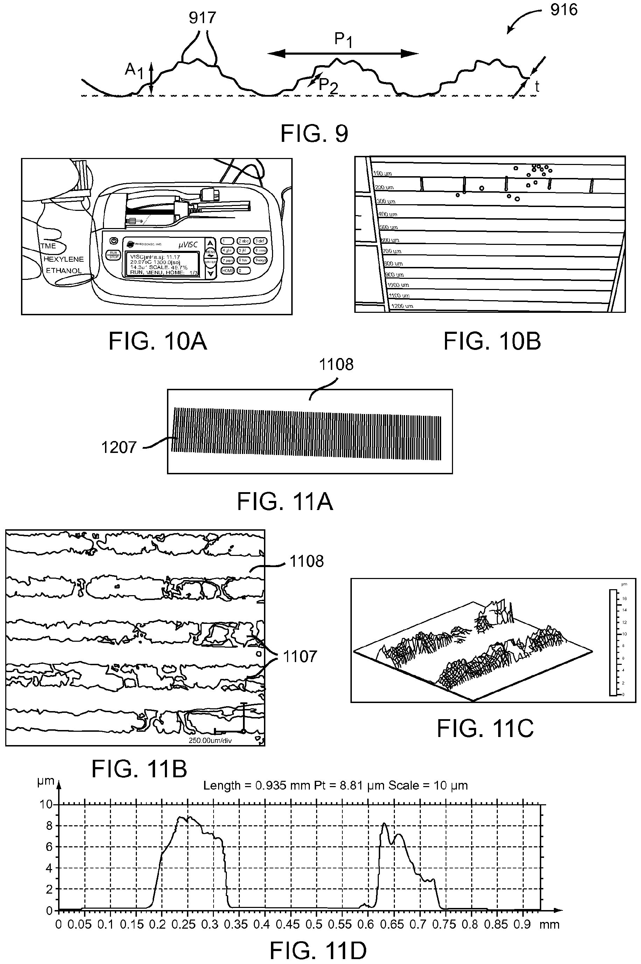

A variety of different sizes and shapes of waveform are also possible. In most cases, the predefined waveform topography would have a period of 10-100µm, a peak-to-peak amplitude of 1-50µm and a sinusoidal configuration. Nevertheless, substantially square, triangular and sawtooth waveforms could also be used, which may or may not have an amplitude and period within the above-mentioned ranges. Figure 9 shows a further configuration comprising a main waveform 916 and a sub-waveform 917 formed on top of the main waveform 916, the sub-waveform 917 having a smaller period (P₁, P₂) and amplitude (A₁) than the main waveform 916. This hierarchical configuration provides more stress relief than a single waveform and may be extended to include further sub-waveforms, each having a smaller period and amplitude than the hierarchically-preceding waveform.

A range of different materials could be used to form the substrate scaffold structure described herein, although the specific materials used will depend on whether or not the substrate scaffold structure is to be removed after deposition of the thin film layers, the expected level of operational reversible deformation in the event that the substrate scaffold structure is not to be removed, the process used to form the substrate scaffold structure, and/or the process used to remove the substrate scaffold structure. For example, if the substrate scaffold structure is not to be removed after deposition of the thin film layers, then reversibly deformable polymeric materials such as polyurethane, polydimethylsiloxane and low-density polyethylene may be used. The Young's modulus of such materials is typically in the range of 0.1 to 100 MPa. If, however, the substrate scaffold structure is to be removed by sublimation, then trimethylolethane is a suitable candidate.

The materials and thicknesses of the one or more scaffold-conforming thin film layers will depend on the specific electronic circuit elements that are required for the particular device, but will typically comprise conducting, semiconducting and/or insulating materials with individual layer thicknesses of 10-500nm and a total combined thickness of less than 5µm. Given that the thin film layers are formed with a predefined waveform configuration, and are therefore able to accommodate a corresponding degree of mechanical deformation, they need not be formed from reversibly deformable materials. For example, they could comprise brittle materials such as ceramics.

Figures 10-14 show the results of an experiment that was performed to demonstrate the concepts described herein.

Trimethyloloethane (TME), purchased as pure granules from GEO Specialty Chemicals, was dissolved into a solvent consisting of hexylene glycol, ethanol and deionized water at equal weight ratios (25wt% of each component) and mixed for an hour at 50°C on a stirrer hotplate. The viscosity of the resulting ink measured 11mPa s (measured on RheoSence uVisc system), as shown in Figure 10a. The TME ink was filtered at 0.2µm when loaded into a Dimatix Materials Printer cartridge. Excellent jetting was observed with all 16 nozzles (with 10pL nominal drop volume) when driven at 16V, as shown in Figure 10b.

The ink was printed at 40µm drop spacing onto Dupont Teonex PEN Q65FA substrate 1108 when the printer platen was held at 60°C. The resulting features were well-defined, but the remaining solidified TME lines 1107 were discontinuous (which occurred during the drying and solidifying phase), as seen in the photo of Figure 11a and the microscope image of Figure 11b. The printing was repeated 5 times to achieve a line thickness of ca. 8-10µm as shown in Figures 11c-d.

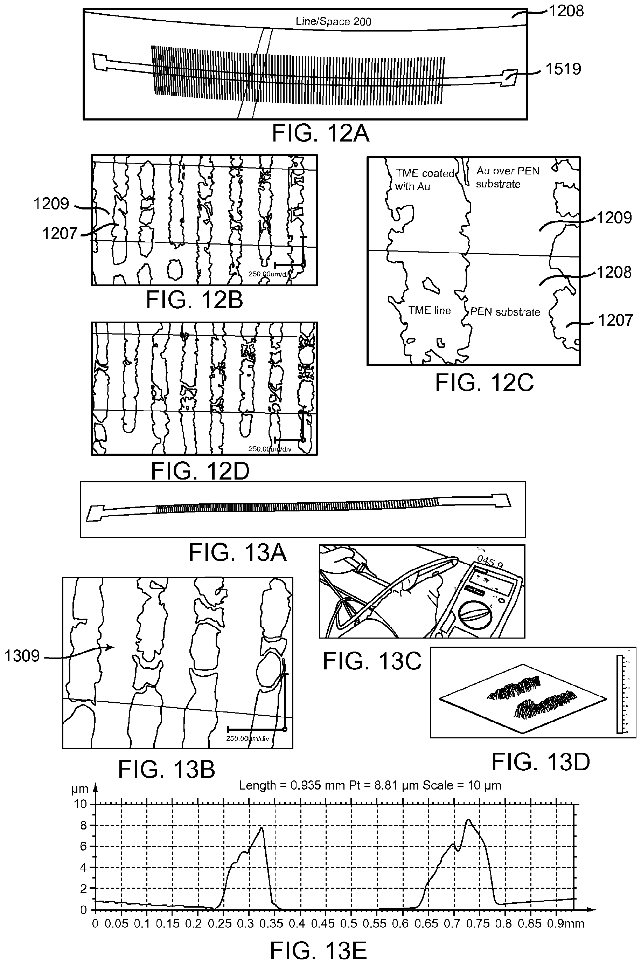

A 5nm thick layer of titanium followed by a 100nm layer of gold were then e-beam evaporated through a mask to form a continuous line 1209 (1mm wide, 50mm long) crossing the row of inkjet-printed TME lines as shown in Figure 12a. Figures 12b-d are magnified views of Figure 12a.

The TME lines were then sublimated by placing the sample in an oven at 150°C for approximately. 10mins. The photo in Figure 13a shows that after sublimation there was no visible trace of the TME by the naked eye, whilst the titanium-gold thin film structure 1309 remained mostly intact. The resulting waveform configuration is visible in the microscope image in Figure 13b and in the profile scans shown in Figures 11d-e. The end-to-end resistance of the line 1309 was then measured as shown in Figure 13c and was found to be 46Ω, i.e. roughly 1Ω/sq, which is about four times higher than should be expected for a 100nm thick layer of pure gold. Nevertheless, no reference structure was evaporated onto a bare polyethylene naphthalate (PEN) substrate to provide a proper measurement of the resistive effect of the rippled structure.

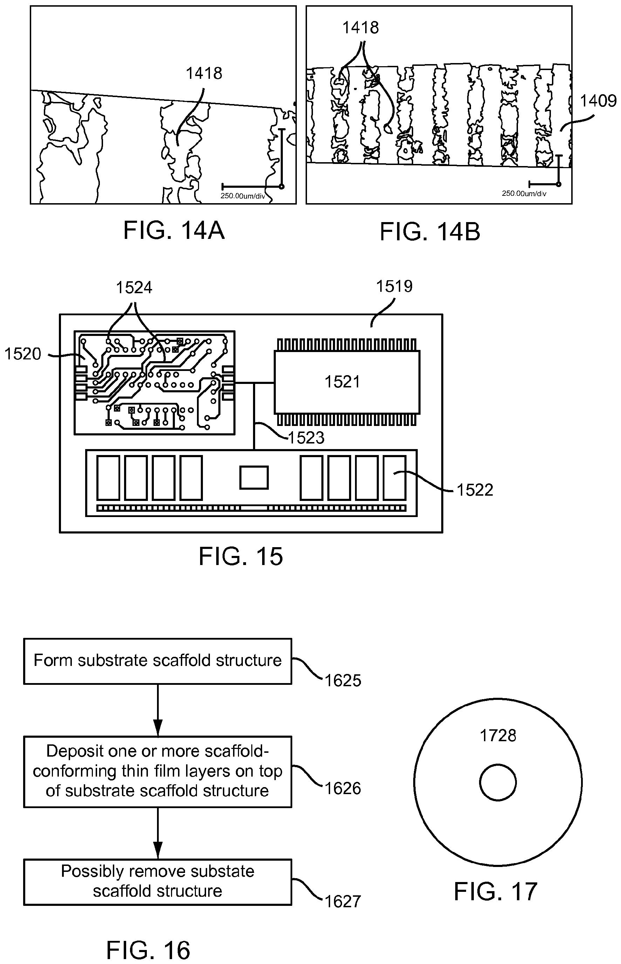

Some holes 1418 were visible where the gold layer had partially broken, as shown in Figures 14a-b. As mentioned previously, such defects 1418 could have been avoided by first depositing a thin supporting layer onto which the functional thin-film layers 1409 can be layered.

Figure 15 shows one example of an apparatus 1519 comprising a reversibly deformable circuit board 1520 formed using a substrate scaffold structure, a processor 1521 and a storage medium 1522, which are electrically connected to one another by a data bus 1523. The processor 1521 and storage medium 1522 may or may not form part of the reversibly deformable circuit board 1520, which may be a motherboard or module of the apparatus 1519. The apparatus 1519 may be one or more of an electronic device, a portable electronic device, a portable telecommunications device, a mobile phone, a PDA, a desktop computer, a laptop computer, and a tablet computer.

The reversibly deformable circuit board 1520 comprises electronic circuit elements 1524 formed from one or more thin film layers of the reversibly deformable circuit board 1520. The one or more thin film layers comprise a predefined waveform configuration facilitating operational reversible deformation of the circuit board 1520 between a relaxed state and a strained state, and the electronic circuit elements 1524 are in a substantially neutral stress state when the reversibly circuit board 1520 is in the relaxed state. The reversibly deformable circuit board 1520 may also comprise a substrate scaffold structure on which the one or more thin film layers are formed, the substrate scaffold structure comprising a predefined waveform topography substantially corresponding to the predefined waveform configuration of the one or more thin film layers. The electronic circuit elements 1524 may comprise one or more electronic components (such as a transistor, a diode, an OLED, an LEC, a solar cell, a sensor, an antenna or a touch sensor) and/or conductive traces for connecting electronic components as well as barrier layers protecting underlying sensitive thin-film layers such as those of OLED pixels.

The processor 1521 is configured for general operation of the apparatus 1519 by providing signalling to, and receiving signalling from, the other components to manage their operation. The storage medium 1522 is configured to store computer code configured to perform, control or enable operation of the apparatus 1519. The storage medium 1522 may also be configured to store settings for the other components. The processor 1521 may access the storage medium 1522 to retrieve the component settings in order to manage the operation of the other components. The processor 1521 may be a microprocessor, including an Application Specific Integrated Circuit (ASIC). The storage medium 1522 may be a temporary storage medium such as a volatile random access memory. On the other hand, the storage medium 1522 may be a permanent storage medium such as a hard disk drive, a flash memory, or a non-volatile random access memory.

The main steps 1625-1627 of a method of forming a reversibly deformable circuit board using a substrate scaffold structure are shown schematically in Figure 16. The method generally comprises: forming 1625 a substrate scaffold structure; depositing 1626 one or more scaffold-conforming thin film layers on top of the substrate scaffold structure; and possibly removing 1627 the substrate scaffold structure after deposition of the one or more scaffold-conforming thin film layers (depending upon particular operational requirements and properties of the substrate scaffold structure). As described previously, a variety of different processes may be used to perform each step of the method.

Figure 17 illustrates schematically a computer/processor readable medium 1728 providing a computer program according to one embodiment. The computer program may comprise computer code configured to perform, control or enable one or more of the method steps 1625-1627 of Figure 16. In this example, the computer/processor readable medium 1728 is a disc such as a digital versatile disc (DVD) or a compact disc (CD). In other embodiments, the computer/processor readable medium 1728 may be any medium that has been programmed in such a way as to carry out an inventive function. The computer/processor readable medium 1728 may be a removable memory device such as a memory stick or memory card (SD, mini SD, micro SD or nano SD).

Other embodiments depicted in the figures have been provided with reference numerals that correspond to similar features of earlier described embodiments. For example, feature number 1 can also correspond to numbers 101, 201, 301 etc. These numbered features may appear in the figures but may not have been directly referred to within the description of these particular embodiments. These have still been provided in the figures to aid understanding of the further embodiments, particularly in relation to the features of similar earlier described embodiments.

It will be appreciated to the skilled reader that any mentioned apparatus/device and/or other features of particular mentioned apparatus/device may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/functional units.

In some embodiments, a particular mentioned apparatus/device may be pre-programmed with the appropriate software to carry out desired operations, and wherein the appropriate software can be enabled for use by a user downloading a "key", for example, to unlock/enable the software and its associated functionality. Advantages associated with such embodiments can include a reduced requirement to download data when further functionality is required for a device, and this can be useful in examples where a device is perceived to have sufficient capacity to store such pre-programmed software for functionality that may not be enabled by a user.

It will be appreciated that any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).

It will be appreciated that any "computer" described herein can comprise a collection of one or more individual processors/processing elements that may or may not be located on the same circuit board, or the same region/position of a circuit board or even the same device. In some embodiments one or more of any mentioned processors may be distributed over a plurality of devices. The same or different processor/processing elements may perform one or more functions described herein.

It will be appreciated that the term "signalling" may refer to one or more signals transmitted as a series of transmitted and/or received signals. The series of signals may comprise one, two, three, four or even more individual signal components or distinct signals to make up said signalling. Some or all of these individual signals may be transmitted/received simultaneously, in sequence, and/or such that they temporally overlap one another.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/embodiments may consist of any such individual feature or combination of features. In view of the foregoing description it will be evident to a person skilled in the art that various modifications may be made within the scope of the disclosure.

While there have been shown and described and pointed out fundamental novel features as applied to different embodiments thereof, it will be understood that various omissions and substitutions and changes in the form and details of the devices and methods described may be made by those skilled in the art without departing from the scope of the claims.

For example, it is expressly intended that all combinations of those elements and/or method steps which perform substantially the same function in substantially the same way to achieve the same results are within the scope of the invention. Moreover, it should be recognized that structures and/or elements and/or method steps shown and/or described in connection with any disclosed form or embodiment may be incorporated in any other disclosed or described or suggested form or embodiment as a general matter of design choice. Furthermore, in the claims means-plus-function clauses are intended to cover the structures described herein as performing the recited function and not only structural equivalents, but also equivalent structures. Thus although a nail and a screw may not be structural equivalents in that a nail employs a cylindrical surface to secure wooden parts together, whereas a screw employs a helical surface, in the environment of fastening wooden parts, a nail and a screw may be equivalent structures.

## Claims

1. A method comprising:
forming a substrate scaffold structure (307, 707) for use in the fabrication of a reversibly deformable circuit board (1520), the substrate scaffold structure (307, 707) comprising a predefined waveform topography (916, 917) , the waveform topography (916, 917) of the substrate scaffold structure (307, 707) predefined to facilitate operational reversible deformation of the circuit board (1520);
depositing one or more scaffold-conforming thin film layers (309, 409) on top of the substrate scaffold structure (307, 707), the one or more scaffold-conforming thin film layers being adapted for use in forming electronic circuit elements (1524) of the reversibly deformable circuit board (1520);
wherein the waveform topography (916, 917) comprises a main waveform and a sub-waveform formed on top of the main waveform, and wherein the sub-waveform has a smaller period and amplitude than the main waveform.

2. The method of claim 1, comprising removing the substrate scaffold structure (307, 707) after deposition of the one or more scaffold-conforming thin film layers (309, 409).

3. The method of claim 1 or 2, wherein the waveform topography (916, 917) of the substrate scaffold structure (307, 707) is predefined to facilitate reversible deformation of the electronic circuit elements (1524) during operational reversible deformation of the circuit board (1520).

4. The method of any of claim 1 to 3, wherein the method comprises forming the substrate scaffold structure (307, 707) from, or on top of, a reversibly deformable substrate (308) of the circuit board (1520).

5. The method of claim 2, wherein the method comprises transferring the one or more scaffold-conforming thin film layers (309, 409) onto a reversibly deformable substrate (308) of the circuit board (1520) after removal of the substrate scaffold structure (307, 707) and whilst the reversibly deformable substrate (308) is in a relaxed state.

6. The method of claim 2, wherein the method comprises depositing a scaffold-conforming support layer on top of the substrate scaffold structure (307, 707) before deposition of the one or more scaffold-conforming thin film layers (309, 409) to reduce the formation of defects (1418) in the one or more scaffold-conforming thin film layers (309, 409) caused by removal of the substrate scaffold structure (307, 707).

7. The method of claim 2, wherein the method comprises:
depositing a plurality of scaffold-conforming thin film layers (309, 409) on top of the substrate scaffold structure (307, 707); and
removing the substrate scaffold structure (307, 707) after the first thin film layer (310) has been deposited but before the last thin film layer (311) has been deposited.

8. The method of claim 2, wherein the method comprises forming the one or more scaffold-conforming thin film layers (309, 409) to allow access to the underlying substrate scaffold structure (307, 707) to enable its removal.

9. The method of any preceding claim, wherein forming the substrate scaffold structure (307, 707) comprises:
modifying the surface chemistry of a substrate (708) in a pattern corresponding to the predefined waveform topography (916, 917);
depositing an ink onto the modified surface of the substrate (708);
allowing interactions between the ink and the modified surface to form a plurality of ink droplets (715) in substantially the same pattern as the modified surface; and
heating the substrate (708) to cure the ink droplets (715).

10. A reversibly deformable circuit board (1520) comprising:
- a substrate scaffold structure (307, 707) made of cured ink droplets and comprising a predefined waveform topography (916, 917) ;
- one or more thin film layers (309, 409) disposed on the substrate scaffold structure (307, 707) and comprising a waveform configuration corresponding substantially to the waveform topography (916, 917) of the substrate scaffold structure (307, 707);
- electronic circuit elements (1524) formed from the one or more thin film layers (309, 409) of the reversibly deformable circuit board (1520),
wherein the predefined waveform topography (916, 917) comprises a main waveform and a sub-waveform formed on top of the main waveform, and wherein the sub-waveform has a smaller period and amplitude than the main waveform, and
wherein the waveform topography (916, 917) is provided for facilitating operational reversible deformation of the circuit board (1520) between a relaxed state and a strained state, and wherein the electronic circuit elements (1524) are in a substantially neutral stress state when the reversibly deformable circuit board (1520) is in the relaxed state.

## Patentansprüche

1. Verfahren, das Folgendes umfasst:
Bilden einer Substratgerüststruktur (307, 707) zur Verwendung bei der Herstellung einer umkehrbar verformbaren Leiterplatte (1520), wobei die Substratgerüststruktur (307, 707) eine vordefinierte Wellenformtopographie (916, 917) umfasst, wobei die Wellenformtopographie (916, 917) der Substratgerüststruktur (307, 707) vordefiniert ist, um eine betriebsmäßige umkehrbare Verformung der Leiterplatte (1520) zu ermöglichen;
Auftragen von einer oder mehreren gerüstkonformen Dünnfilmschichten (309, 409) auf die Substratgerüststruktur (307, 707), wobei die eine oder die mehreren gerüstkonformen Dünnfilmschichten zur Verwendung beim Bilden von elektronischen Schaltungselementen (1524) der umkehrbar verformbaren Leiterplatte (1520) angepasst sind;
wobei die Wellenformtopographie (916, 917) eine Hauptwellenform und eine Unterwellenform, die auf der Hauptwellenform gebildet ist, umfasst und wobei die Unterwellenform eine kleinere Periode und Amplitude als die Hauptwellenform aufweist.

2. Verfahren nach Anspruch 1, das nach dem Auftragen der einen oder der mehreren gerüstkonformen Dünnfilmschichten (309, 409) das Entfernen der Substratgerüststruktur (307, 707) umfasst.

3. Verfahren nach Anspruch 1 oder 2, wobei die Wellenformtopographie (916, 917) der Substratgerüststruktur (307, 707) vordefiniert ist, um eine umkehrbare Verformung der elektronischen Schaltungselemente (1524) während einer betriebsmäßigen umkehrbaren Verformung der Leiterplatte (1520) zu ermöglichen.

4. Verfahren nach einem der Ansprüche 1 bis 3, wobei das Verfahren das Bilden der Substratgerüststruktur (307, 707) aus einem umkehrbar verformbaren Substrat (308) der Leiterplatte (1520) oder auf demselben umfasst.

5. Verfahren nach Anspruch 2, wobei das Verfahren nach Entfernung der Substratgerüststruktur (307, 707) und während sich das umkehrbar verformbare Substrat (308) in einem entspannten Zustand befindet, das Übertragen der einen oder der mehreren gerüstkonformen Dünnfilmschichten (309, 409) auf ein umkehrbar verformbares Substrat (308) der Leiterplatte (1520) umfasst.

6. Verfahren nach Anspruch 2, wobei das Verfahren vor dem Auftrag der einen oder der mehreren gerüstkonformen Dünnfilmschichten (309, 409) das Auftragen einer gerüstkonformen Stützschicht auf die Substratgerüststruktur (307, 707) umfasst, um die Bildung von Fehlern (1418) in der einen oder den mehreren gerüstkonformen Dünnfilmschichten (309, 409) zu verringern, die durch das Entfernen der Substratgerüststruktur (307, 707) verursacht werden.

7. Verfahren nach Anspruch 2, wobei das Verfahren Folgendes umfasst:
Auftragen einer Vielzahl von gerüstkonformen Dünnfilmschichten (309, 409) auf die Substratgerüststruktur (307, 707); und
Entfernen der Substratgerüststruktur (307, 707), nachdem die erste Dünnfilmschicht (310) aufgetragen wurde, aber bevor die letzte Dünnfilmschicht (311) aufgetragen wurde.

8. Verfahren nach Anspruch 2, wobei das Verfahren das Bilden der einen oder der mehreren gerüstkonformen Dünnfilmschichten (309, 409) umfasst, um einen Zugang zur darunter liegenden Substratgerüststruktur (307, 707) zu erlauben, um deren Entfernung zu ermöglichen.

9. Verfahren nach einem der vorhergehenden Ansprüche, wobei das Bilden der Substratgerüststruktur (307, 707) Folgendes umfasst:
Modifizieren der Oberflächenchemie eines Substrats (708) in einem Muster, das der vordefinierten Wellenformtopographie (916, 917) entspricht;
Auftragen einer Tinte auf die modifizierte Oberfläche des Substrats (708) ;
Erlauben von Interaktionen zwischen der Tinte und der modifizierten Oberfläche, um eine Vielzahl von Tintentröpfchen (715) im im Wesentlichen selben Muster wie die modifizierte Oberfläche zu bilden; und
Erwärmen des Substrats (708), um die Tintentröpfchen (715) auszuhärten.

10. Umkehrbar verformbare Leiterplatte (1520), die Folgendes umfasst:
- eine Substratgerüststruktur (307, 707), die aus ausgehärteten Tintentröpfchen besteht und eine vordefinierte Wellenformtopographie (916, 917) umfasst;
- eine oder mehrere Dünnfilmschichten (309, 409), die auf der Substratgerüststruktur (307, 707) angeordnet sind und eine Wellenformauslegung umfassen, die im Wesentlichen der Wellenformtopographie (916, 917) der Substratgerüststruktur (307, 707) entspricht;
- elektronische Schaltungselemente (1524), die aus der einen oder den mehreren Dünnfilmschichten (309, 409) der umkehrbar verformbaren Leiterplatte (1520) gebildet sind,
wobei die vordefinierte Wellenformtopographie (916, 917) eine Hauptwellenform und eine Unterwellenform, die auf der Hauptwellenform gebildet ist, umfasst und wobei die Unterwellenform eine kleinere Periode und Amplitude als die Hauptwellenform aufweist, und
wobei die Wellenformtopographie (916, 917) zum Ermöglichen einer betriebsmäßigen umkehrbaren Verformung der Leiterplatte (1520) zwischen einem entspannten Zustand und einem belasteten Zustand bereitgestellt wird und wobei sich die elektronischen Schaltungselemente (1524) in einem im Wesentlichen neutralen Stresszustand befinden, wenn sich die umkehrbar verformbare Leiterplatte (1520) im entspannten Zustand befindet.

## Revendications

1. Procédé comprenant :
la formation d'une structure de squelette de substrat (307, 707) pour son utilisation dans la fabrication d'une carte de circuit imprimé (1520) déformable de manière réversible, la structure de squelette de substrat (307, 707) comprenant une topographie de forme d'onde (916, 917) prédéfinie, la topographie de forme d'onde (916, 917) de la structure de squelette de substrat (307, 707) étant prédéfinie pour faciliter une déformation opérationnelle réversible de la carte de circuit imprimé (1520) ;
le dépôt d'une ou plusieurs couches de film mince adaptées au squelette (309, 409) sur le haut de la structure de squelette de substrat (307, 707), les une ou plusieurs couches de film mince adaptées au squelette étant adaptées pour être utilisées dans la formation d'éléments de circuit électronique (1524) de la carte de circuit imprimé (1520) déformable de manière réversible ;
dans lequel la topographie de forme d'onde (916, 917) comprend une forme d'onde principale et une sous-forme d'onde formée sur le haut de la forme d'onde principale, et dans lequel la sous-forme d'onde a une période et une amplitude inférieures à celles de la forme d'onde principale.

2. Procédé selon la revendication 1, comprenant le retrait de la structure de squelette de substrat (307, 707) après le dépôt des une ou plusieurs couches de film mince adaptées au squelette (309, 409).

3. Procédé selon la revendication 1 ou 2, dans lequel la topographie de forme d'onde (916, 917) de la structure de squelette de substrat (307, 707) est prédéfinie pour faciliter une déformation réversible des éléments de circuit électronique (1524) pendant la déformation opérationnelle réversible de la carte de circuit imprimé (1520).

4. Procédé selon l'une des revendications 1 à 3, dans lequel le procédé comprend la formation de la structure de squelette de substrat (307, 707) à partir d'un substrat déformable de manière réversible (308) de la carte de circuit imprimé (1520) ou sur le haut de celui-ci.

5. Procédé selon la revendication 2, dans lequel le procédé comprend le transfert des une ou plusieurs couches de film mince adaptées au squelette (309, 409) sur un substrat déformable de manière réversible (308) de la carte de circuit imprimé (1520) après le retrait de la structure de squelette de substrat (307, 707) tandis que le substrat déformable de manière réversible (308) est à l'état détendu.

6. Procédé selon la revendication 2, dans lequel le procédé comprend le dépôt d'une couche de support adaptée au squelette sur le haut de la structure de squelette de substrat (307, 707) avant le dépôt des une ou plusieurs couches de film mince adaptées au squelette (309, 409) pour réduire la formation de défauts (1418) dans les une ou plusieurs couches de film mince adaptées au squelette (309, 409) causés par le retrait de la structure de squelette de substrat (307, 707).

7. Procédé selon la revendication 2, dans lequel le procédé comprend :
le dépôt d'une pluralité de couches de film mince adaptées au squelette (309, 409) sur le haut de la structure de squelette de substrat (307, 707) ; et
le retrait de la structure de squelette de substrat (307, 707) après le dépôt de la première couche de film mince (310) mais avant le dépôt de la dernière couche de film mince (311)

8. Procédé selon la revendication 2, dans lequel le procédé comprend la formation des une ou plusieurs couches de film mince adaptées au squelette (309, 409) pour permettre l'accès à la structure de squelette de substrat (307, 707) sousjacente afin de pouvoir la retirer.

9. Procédé selon l'une des revendications précédentes, dans lequel la formation de la structure de squelette de substrat (307, 707) comprend :
la modification de la chimie de surface d'un substrat (708) selon un motif correspondant à la topographie de forme d'onde (916, 917) prédéfinie ;
le dépôt d'une encre sur la surface modifiée du substrat (708) ;
la possibilité des interactions entre l'encre et la surface modifiée pour former une pluralité de gouttelettes d'encre (715) dans un motif sensiblement identique à celui de la surface modifiée ; et
le chauffage du substrat (708) pour durcir les gouttelettes d'encre (715).

10. Carte de circuit imprimé (1520) déformable de manière réversible comprenant :
- une structure de squelette de substrat (307, 707) réalisée en gouttelettes d'encre durcies et comprenant une topographie de forme d'onde (916, 917) prédéfinie ;
- une ou plusieurs couches de film mince (309, 409) disposées sur la structure de squelette de substrat (307, 707) et comprenant une configuration de forme d'onde correspondant sensiblement à la topographie de forme d'onde (916, 917) de la structure de squelette de substrat (307, 707) ;
- des éléments de circuit électronique (1524) formés à partir des une ou plusieurs couches de film mince (309, 409) de la carte de circuit imprimé (1520) déformable de manière réversible,
dans laquelle la topographie de forme d'onde (916, 917) prédéfinie comprend une forme d'onde principale et une sous-forme d'onde formée sur le haut de la forme d'onde principale, et dans laquelle la sous-forme d'onde a une période et une amplitude inférieures à celles de la forme d'onde principale, et
dans laquelle la topographie de forme d'onde (916, 917) est fournie pour faciliter une déformation opérationnelle réversible de la carte de circuit imprimé (1520) entre un état détendu et un état tendu, et
dans laquelle les éléments de circuit électronique (1524) sont dans un état de contrainte sensiblement neutre lorsque la carte de circuit imprimé (1520) déformable de manière réversible est dans l'état détendu.
